# EUROPEAN PATENT SPECIFICATION

(11) **EP 3 120 444 B1**
(45) Date of publication and mention of the grant of the patent: **11.09.2019**
(21) Application number: 15720426.4
(22) Date of filing: 23.03.2015
(51) Int. Cl.: H02K 11/00, H01R 39/58, G01R 31/34

(54) **ALTERNATOR, PREFERABLY FOR AN ELECTRIC POWER PLANT, AND METHOD FOR MONITORING THE CONDITIONS OF AT LEAST ONE SLIDING CONTACT OF AN ALTERNATOR**
WECHSELSTROMGENERATOR, INSBESONDERE FÜR EIN ELEKTRIZITÄTSWERK, UND VERFAHREN ZUR ÜBERWACHUNG DER ZUSTÄNDE VON MINDESTENS EINEM GLEITKONTAKT EINES WECHSELSTROMGENERATORS
ALTERNATEUR, DE PRÉFÉRENCE POUR UNE CENTRALE ÉLECTRIQUE, ET PROCÉDÉ DE SURVEILLANCE DES CONDITIONS D'AU MOINS UN CONTACT GLISSANT D'UN ALTERNATEUR

(30) Priority: 21.03.2014 IT MI20140474
(43) Date of publication of application: 25.01.2017
(73) Proprietor: Ansaldo Energia S.p.A., 16152 Genova (IT)
(72) Inventor: D'AGOSTINO, Fabrizio, I-16143 Genova (IT); DI LIDDO, Sergio, I-16142 Genova (IT); BOTTO, Guido, I-16039 Sestri Levante (IT); VERRECCHIA, Paolo, I-16035 Rapallo (IT); CARASSALE, Riccardo, I-16152 Genova (IT)
(74) Representative: Andreotti, Erika
(86) International application number: PCT/IB2015/052114
(87) International publication number: WO 2015/140773

(56) References cited:
- EP-A1- 2 658 101
- GB-A- 1 476 527

## Description

### TECHNICAL FIELD

The present invention relates to an alternator, preferably for an electric power plant, and to a method of monitoring the conditions of at least one sliding contact of an alternator.

### BACKGROUND ART

Electric power plants usually comprise at least one rotating (steam and/or gas) turbine which drives an alternator, configured to produce electric energy.

The alternators of the known type extend along a longitudinal axis and are provided with a fixed part, the stator, and a movable part, the rotor.

The rotor is housed inside the stator and is supported by two bearings, which are fitted to the rotating shaft of the alternator.

The rotor thus configured rotates driven by the turbine.

The rotor is configured to generate a magnetic field which induces an electromotive force in the stator and is provided with electric windings. The electric windings of the rotor are supplied with a supply current through a collector assembly, which receives the electric current from an energization system and transmits it to the electric windings of the rotor.

The collector assembly is configured to transmit the current from the energization system to the windings of the rotor and is provided with a plurality of sliding contacts, made by means of brushes, preferably of graphite.

In use, a thin conductive film is formed on the brushes due to the presence of coal dust (produced by the same brushes) in conditions of atmospheric humidity.

When the conductive film has non optimal properties of current conduction, dangerous light events occur. Light events may cause early wear of the brushes and insulating elements, increasing the probability of failure and consequent downtime of the electric power plant.

Methods and devices, such as the ones disclosed in documents EP2658101 or GB1476527 for example, are known and able to detect light events using photosensitive sensors or optical sensors. However, such methodologies are not able to make a reliable diagnosis, as they are influenced by the light conditions of the room where the sliding contacts are housed. Background lighting around the sliding contacts can vary depending on the external natural lighting conditions (day/night), or depending on the type of artificial lighting used.

### DISCLOSURE OF INVENTION

It is therefore an object of the present invention to create a simple, cost-effective and reliable alternator. In particular, an object of the present invention is to implement an alternator wherein the conditions of the sliding contacts are monitored in real time so as to prevent irreversible damage to the collector assembly.

According to these objects, the present invention relates to an alternator according to claim 1.

It is a further object of the present invention to provide a method for monitoring the conditions of at least one sliding contact of an alternator which is simple, cost-effective and able to prevent irreversible damage to the collector assembly.

According to these objects, the present invention relates to a method for monitoring the conditions of at least one sliding contact of an alternator according to claim 11.

### BRIEF DESCRIPTION OF THE DRAWINGS

Further features and advantages of the present invention will become apparent from the following description of an exemplary non-limiting embodiment given purely by way of example and with reference to the figures of the accompanying drawings, in which:
- figure 1 is a schematic lateral view of an alternator, preferably of an electric power plant, comprising the monitoring device according to the present invention;
- figure 2 is a schematic lateral view, with sectional parts and parts removed for clarity, of a detail of the alternator in figure 1;
- figure 3 is a schematic front view, with sectional parts and parts removed for clarity, of the detail in figure 2;
- figure 4 is a wiring diagram, with parts removed for clarity, of a particular component in figure 2;
- figure 5 is a schematic front view, with sectional parts and parts removed for clarity, of a further detail in figure 2.

### BEST MODE FOR CARRYING OUT THE INVENTION

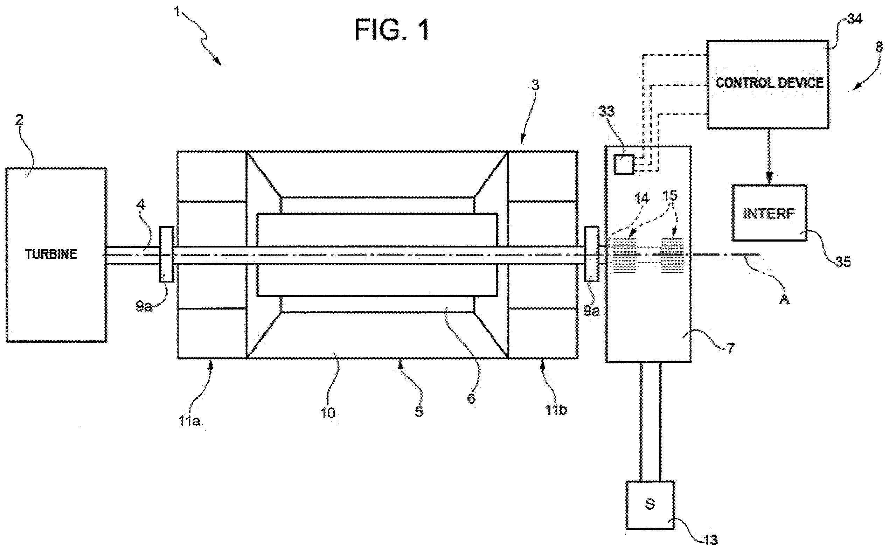

In figure 1, reference numeral 1 indicates an electric power plant comprising a rotating turbine 2 (schematically shown in figure 1) and an alternator 3, which is driven by turbine 2 and is configured to transform the rotary motion imposed by turbine 2 into electric energy.

Alternator 3 extends along a longitudinal axis A and comprises a shaft 4 connected to turbine 2, a stator 5, a rotor 6, a collector assembly 7 and a monitoring device 8.

Stator 5 represents the stationary armature and comprises a cylindrical core 10 and two opposite heads 11a, 11b and a plurality of stator bars (not visible in the accompanying figures). Head 11a is arranged between core 10 and turbine 2.

Core 10 is provided with a plurality of axial slots (not visible in the accompanying figures). Each stator bar extends along a first axis substantially parallel to axis A and within a respective axial slot of core 10 and along two stretches at heads 11.

Rotor 6 is housed inside stator 5 and rotates driven by turbine 2.

In particular, rotor 6 is supported by a first bearing 9a and by a second bearing 9b, which are fitted to shaft 4.

The first bearing 9a is arranged between stator 5 and the collector assembly 7, while the second bearing 9b is arranged between stator 5 and turbine 2.

Rotor 6 is configured so as to generate a rotating magnetic field which induces an electromotive force in stator 5.

In detail, rotor 6 includes a rotor winding provided with a plurality of electromagnets (not visible in the accompanying figures), which are generally defined as rotor winding bars.

The electromagnets of rotor 6 are supplied with a supply current through the collector assembly 7, which receives the electric current from an external source 13 (schematically shown in figure 1) and transmits it to the electromagnets of rotor 6. Generally, the external source 13 is defined by an energization system.

The collector assembly 7 is arranged in the vicinity of head 11b and extends about an end portion 14 of shaft 4, which is provided with two collector rings 15.

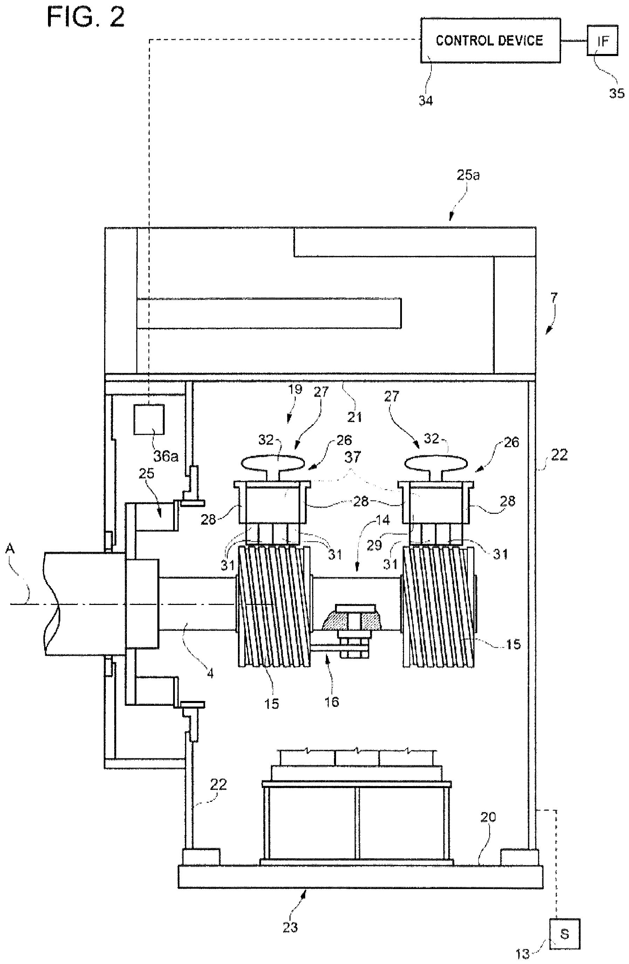

With reference to figure 2, each collector ring 15 is connected to one or more respective electromagnets by means of a respective connection element 16 (only one of the connection elements 16 is visible in figure 2).

The collector assembly 7 includes a chamber 18 and two connection elements 19, which are arranged inside chamber 18 and are configured to electrically connect the external source 13 with the respective collector rings 15 of shaft 4.

Chamber 18 has a bottom wall 20, a roof 21 and two lateral walls 22.

The bottom wall 20 is provided with an air inlet 23 through which cooling air enters from the outside of the collector assembly 7.

Roof 21 is openable and has an opening 25 through which the cooling air that is heated while flowing through chamber 18 flows. Preferably, opening 25 is provided with a silencer filter (not visible in the accompanying figures).

Opening 25 is preferably connected to an open cooling circuit 25a external to chamber 18.

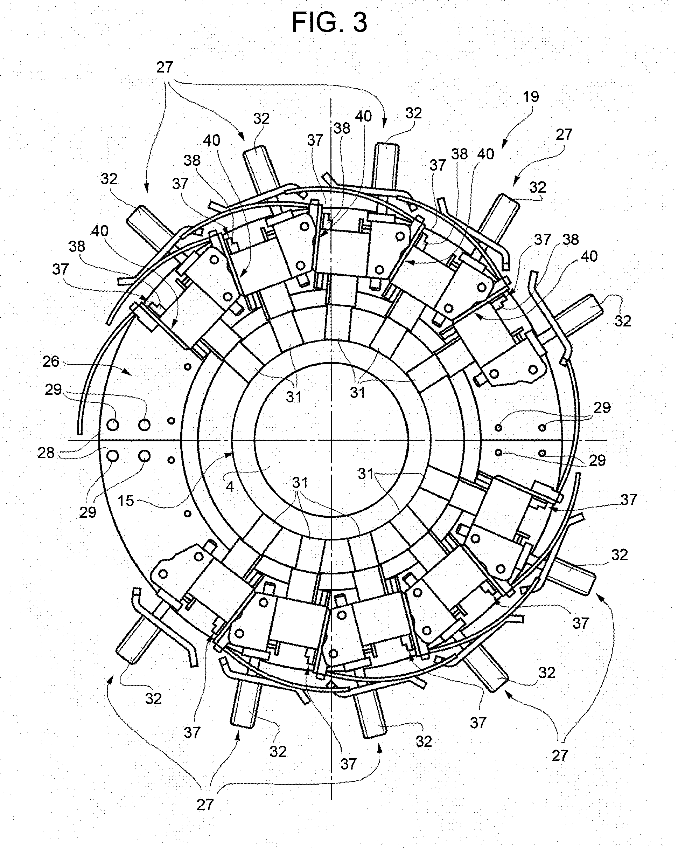

With reference to figure 3, each connection element 19 includes a support frame 26 and a plurality of sliding contacts 27 fixed to the support frame 26.

The support frame 26 is defined by two plates 28 shaped as a half-ring and coupled to each other through a plurality of uprights 29 arranged at predefined distances.

The support frame 26 thus defined is fixed to the lateral walls of chamber 18 by means of bolts (not shown in the accompanying figures). A variant provides for the support frame 26 to be fixed to a metal partition which houses the fan (not shown for simplicity in the accompanying figures) of the cooling circuit 25a.

In particular, the support frame 26 is fixed in such a way that the sliding contacts 27 of each connection element 19 are arranged in contact with the respective collector ring 15.

Each sliding contact 27 is defined by a brush holder 30 and by one or more brushes 31 coupled to the brush holder 30.

The brush holder 30 is coupled, in use, to the support frame 26 through respective shelves, not shown for simplicity in the accompanying figures.

In particular, the brush holders 30 are coupled to frame 26 so that brushes 31 define one next to the other substantially an annular contact surface, adapted to slide against the outer surface of the respective collector ring 15.

Each brush holder 30 is provided with a gripping handle 32 adapted to facilitate the mounting and removal of the sliding contacts 27 from the support frame 26 and speed up the routine and extraordinary maintenance operations.

In the non limiting example described and illustrated herein, each sliding contact 27 includes four brushes 31.

Preferably, brushes 31 are made of graphite.

With reference to figure 1, the monitoring device 8 comprises a group of detection sensors 33 (schematically shown in figure 1), a control device 34 and an interface 35.

With reference to figure 2, the group of detection sensors 33 includes at least one temperature sensor 36a and at least one photodetector 37.

Preferably, the temperature sensor 36a is arranged in the vicinity of opening 25 through which the cooling air that is heated flowing in chamber 18 flows and is therefore configured to detect temperature changes due to the presence of electric events occurring inside chamber 18.

A variant not shown provides for the group of detection sensors 33 to comprise two temperature sensors arranged inside chamber 18; preferably, the two temperature sensors are arranged along opposite inner walls of chamber 18, respectively.

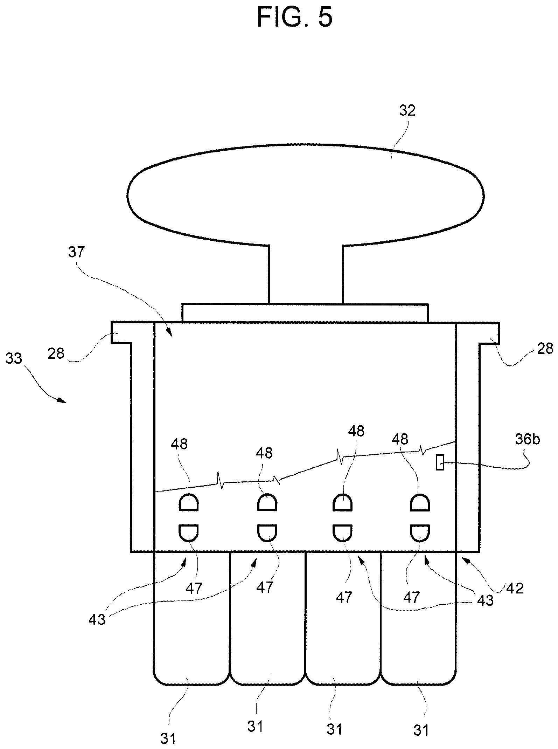

With reference to figure 5, the group of detection sensors 33 further comprises a further temperature sensor 36b which, as will be seen in detail hereafter, is configured to detect any changes in temperature in the vicinity of the sliding contacts 27.

With reference to figure 2, the photodetector device 37 is arranged inside chamber 18 and is configured to detect the intensity and the frequency of the light events occurring inside chamber 18.

In the non limiting example described herein, the monitoring device 8 comprises a plurality of photodetector devices 37 associated to respective sliding contacts 27.

With reference to figure 5, each photodetector device 37 is fixed to a support plate 38, which is coupled to a portion 42 of a respective brush holder 30. Portion 42 is preferably flat and arranged along a radial direction with respect to axis A.

In the non limiting example described and illustrated herein, each sliding contact 27 is coupled to a photodetector device 37 capable of detecting light events associated with electric events at brushes 31. A variant not shown provides for the photodetector devices 37 to be coupled to half of the sliding contacts 27, for example to one sliding contact 27 out of two.

In the non limiting example described and illustrated herein, the temperature sensor 36b is fixed to the support plate 38 in such a position as to be able to detect any temperature variations in the vicinity of the sliding contacts 27. Preferably, the temperature sensor 36b is a thermistor, for example of NTC (negative temperature coefficient) type or of the PTC (positive temperature coefficient) type.

The support plate 38 also supports a plurality of photocells (not visible in the accompanying figures) configured to detect the level of consumption of brushes 31.

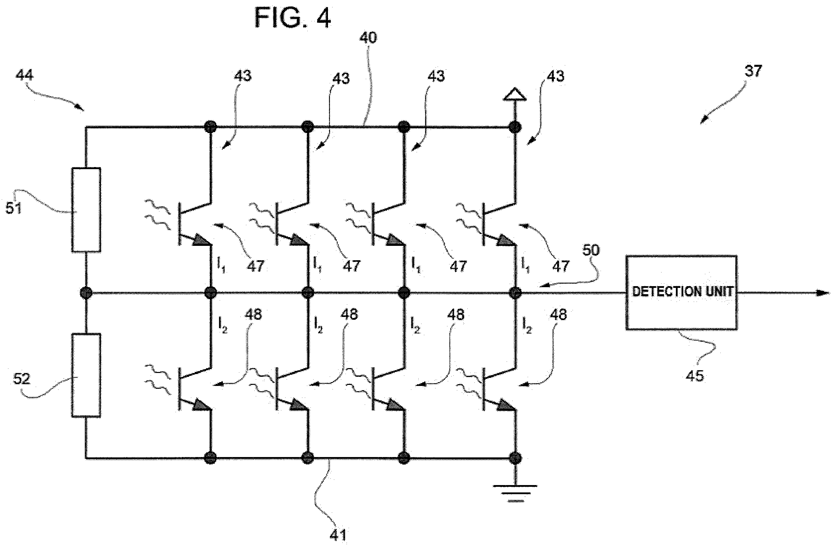

Figure 4 shows the electric circuit of one of the photodetectors devices 37 coupled to a brush holder 30.

The photodetector device 37 comprises a first line 40 having a first electric potential, a second line 41 having a second electric potential, at least one photodetector group 43, a load assembly 44 and a detection unit 45.

The first line 40 preferably has an electric potential of between 4V and 6V, preferably 5V, while the second line 41 is preferably grounded.

In the non limiting example described and illustrated herein, each photodetector device 37 comprises four photodetector groups 43 which are substantially identical, each of which is configured, as will be seen in detail hereafter, to detect light events associated with a respective brush 31 of the respective sliding contact 27.

Each photodetector group 43 comprises a first photodetector 47 and a second photodetector 48, which have a common node 50.

The first photodetector 47 and the second photodetector 48 are configured to detect an electromagnetic radiation generating a current or a potential difference of intensity proportional to the intensity of the electromagnetic radiation detected.

In the non limiting example described and illustrated herein, the first photodetector 47 and the second photodetector 48 are semiconductor photodetectors, preferably photodiodes.

It is understood that the first photodetector 47 and the second photodetector 48 may be defined by semiconductor photodetectors of different types, such as phototransistors, photoresistors, photovoltaic cells, CCD, etc.

The first photodetector 47 of each photodetector group 43 is connected to the first line 40 and to the common node 50 and is configured to generate, in response to a corresponding photon excitation, a first current I1 entering the common node 50. The second photodetector 48 of 41 and to the common node 50 and is configured to generate, in response to a corresponding photon excitation, a second current 12 exiting the common node 50.

An equivalent variant not shown provides for the first photodetector 47 and the second photodetector 48 to be configured to generate a first current I1 exiting from node 50 and a second current 12 entering node 50, respectively, in response to a respective photonic excitation.

The load assembly 44 comprises a first load 51 connected to the first line 40 and to the common node 50 and a second load 52 connected to the second line 41 and to the common node 50. Preferably, the first load 51 and the second load 52 have the same value of electric resistance.

The first photodetector 47 is arranged so as to frame a region of chamber 18 comprising at least a part of the sliding contact 27 to which the photodetector device 37 is coupled, the second photodetector 48 is arranged so as to frame a region of chamber 18 not comprising the sliding contact 27 to which the photodetector device 37 is coupled. Wherein the expression "frame a region of the chamber 18" has to be intended as detecting the light in a region of the chamber 18.

In this way, the first photodetector 47 detects any electric events associated to one or more brushes 31 of the sliding contact 27, while the second photodetector 48 detects the background lighting in chamber 18.

With reference to figure 2, which shows a partially sectional photodetector device 37, the photodetector groups 43 are arranged in such a way that the first photodetector 47 of each photodetector group 43 detects the light events associated to a respective brush 31 of a same sliding contact 27. In other words, the photodetector groups 43 are arranged in such a way that the first photodetector 47 of each photodetector group 43 frames a region of chamber 18 comprising the respective brush 31 to be monitored.

In particular, the photodetector groups 43 are fixed to the support plate 38 and are arranged next to each other substantially equally spaced, so that the first photodetector 47 of each photodetector group 43 can detect the light events associated with the respective brushes 31.

With reference to figure 4, the detection unit 45 is configured to detect current variations in output from the common node 50 and/or voltage variations at the common node 50. In particular, the detection unit 45 is configured to send a signal to the control device 34 indicative of the presence of a spark associated with that specific photodetector device 37 when the current and/or voltage variation detected exceeds a certain predetermined threshold value. Preferably, the detection unit 45 sends a signal to the control device 34 indicative of the frequency of the light events, of the intensity of the light events and of the maximum width of the light events detected.

In use, when at least one of the first photodetectors 47 detects a spark on the respective brush 31, it generates a first current I1 in input to the common node 50 having a value greater than the current generated by the second photodetector 48.

The second photodetector 48, in fact, generates a second current 12 in response to a light emission depending on the light conditions present at that time inside chamber 18. The first photodetector 47, on the other hand, generates a first current I1 in response to a light emission depending on the light conditions present at that time inside chamber 18 and on the photon emissions associated with the electric event. As a consequence, there will be a voltage and current variation at node 50. Such a variation is detected by the detection unit 45 and if the variation exceeds the predefined threshold value, the detection unit 45 sends a signal to the control device 34 indicative of the presence of a spark associated with that specific photodetector device 37.

Conversely, if the first photodetector 47 does not detect any spark, the first current I1 and the second current 12 are identical since the first photodetector 47 and the second photodetector 48 detect the same photon emissions associated with the light conditions present at that time inside chamber 18. As a result, there will be no voltage or current variations at the common node 50 and the detection unit 45 will detect no variation sufficient to cause the sending of a signal indicative of the presence of a spark associated with that specific photodetector device 37.

Thanks to the fact that the first photodetector 47 is arranged so as to frame a region of chamber 18 comprising at least a part of the sliding contact 27 to which the photodetector device 37 is coupled and the second photodetector 48 is arranged so as to frame a region of chamber 18 not comprising the sliding contact 27 to which the photodetector device 37 is coupled, the photodetector device 37 is not affected by the light conditions of chamber 18. Thanks to the special connection between the first photodetector 47 and the second photodetector 48, the background contribution determined by the instantaneous light conditions of chamber 18 is annulled and the detector device 37 is not affected by the surrounding light conditions external to the sliding contacts 27.

The control device 34 is configured to determine the operating state of at least one sliding contact 27 based on the data detected by at least a part of the group of sensors 33. In the non limiting example described and illustrated herein, the control device 34 is configured to determine the operating state of at least one sliding contact 27 based on the temperature data detected by the temperature sensor 36 and based on the signals coming from the photodetector devices 37 present in chamber 18. A variant provides for the control device 34 to be configured to determine the operating state of at least one sliding contact 27 based on the data coming from the photodetector devices 37 present in chamber 18, alone or in combination with data coming from other known sensors, not described.

In particular, the control device 34 is configured to determine an operating state of at least one sliding contact 27 selected from at least two of the following states:
- correct operating state;
- first incorrect operating state;
- second incorrect operating state;
- third incorrect operating state;
- fourth incorrect operating state.

Moreover, the control device 34 is configured to signal, through interface 35, the operating state determined, so that the operator may promptly act and troubleshoot any failures.

In detail, the control device 34 is configured to determine the correct operating state when the following conditions are met:
- the temperature detected by the temperature sensor 36a and/or by at least one temperature sensor 36b is less than a first temperature threshold;
- the intensity and frequency of light events detected by all the photodetector devices 37 are substantially null.

The control device 4 determines the first incorrect operation state (WARNING 1) when the following conditions are met:
- the temperature detected by the temperature sensor 36a and/or by at least one temperature sensor 36b is less than the first temperature threshold;
- the intensity and frequency of the light events detected by at least one photodetector device 37 is other than zero and lower than a first intensity threshold and a first frequency threshold, respectively.

The control device 4 determines the second incorrect operation state (WARNING 2) when the following conditions are met:
- the temperature detected by the temperature sensor 36a and/or by at least one temperature sensor 36b is less than the first temperature threshold;
- the intensity of the light events detected by at least one photodetector device 37 is between the first intensity threshold and a second intensity threshold; and the frequency of the light events detected by at least one photodetector device 37 is between the first frequency threshold and a second frequency threshold.

The control device 4 determines the third incorrect operation state (WARNING 3) when the following conditions are met:
- the temperature detected by the temperature sensor 36a and/or by at least one temperature sensor 36b is between the first temperature threshold and a second temperature threshold;
- the intensity of the light events detected by at least one photodetector device 37 is between the first intensity threshold and a second intensity threshold; and the frequency of the light events detected by at least one photodetector device 37 is between the first frequency threshold and a second frequency threshold.

The control device 4 determines the fourth incorrect operation state (WARNING 4) when the following conditions are met:
- the temperature detected by the temperature sensor 36a and/or by at least one temperature sensor 36b is more than the second temperature threshold;
- the intensity of the light events detected by at least one photodetector device 37 is more than the second intensity threshold and the frequency of the light events detected by at least one photodetector device 37 is more than the second frequency threshold.

The first temperature threshold, the second temperature threshold, the first intensity threshold, the second intensity threshold, the first frequency threshold and the second frequency threshold are determined during the calibration step ("tuning") of the control device 34 based on the type of machine.

The number of incorrect operating states may vary depending on the needs and on the type of machine on which the monitoring device 8 is mounted.

Preferably, the control device 34 includes a memory unit (not shown in the accompanying figures) which stores all the data acquired. Such a memory unit is accessible by the operator through interface 35. In this way, the operator may see the history of the data acquired for further diagnostic assessment.

Advantageously, the monitoring device 8 of alternator 3 according to the present invention performs a continuous monitoring of the sliding contacts 27, increasing the reliability of alternator 3.

If the monitoring device 8 identifies an incorrect operating state of the sliding contacts 27, the operator notified via interface 35 may, depending on the severity of the failure, schedule one or more maintenance operations or even block plant 1 before irreversible damage to plant 1 itself is caused.

Advantageously, the monitoring device 8 of alternator 3 carries out a reliable diagnosis of the sliding contacts 27, avoiding false positives and/or false negatives.

Moreover, the use of photodetector devices 37 of the type described makes the detection of light events independent of the light conditions of chamber 8.

In fact, thanks to the fact that the first photodetector 47 is arranged so as to frame a region of chamber 18 comprising at least a part of the sliding contact 27 to which the photodetector device 37 is coupled and the second photodetector 48 is arranged so as to frame a region of chamber 18 not comprising the sliding contact 27 to which the photodetector device 37 is coupled, the photodetector device 37 is not affected by the light conditions of chamber 18. Moreover, thanks to the special connection between the first photodetector 47 and the second photodetector 48, the background contribution determined by the instantaneous light conditions of chamber 18 is annulled and the detector device 37 is not affected by the surrounding light conditions external to the sliding contacts 27.

Finally, it is clear that the alternator and the monitoring method described herein may be modified and varied without departing from the scope of the appended claims.

## Claims

1. Alternator, preferably for an electric power plant (1), extending along a longitudinal axis (A) and comprising a stator (5), a rotor (6), which is housed inside the stator (5) and is provided with a rotating shaft (4) and with a plurality of electromagnets, and a collector assembly (7), which is configured to supply current to the electromagnets of the rotor (6) and is provided with a chamber (18) and with at least one first sliding contact (27) housed inside the chamber (18); the alternator (3) comprising:
- a monitoring device (8) for monitoring the conditions of at least the first sliding contact (27) and comprising at least one first photodetector (47) and one second photodetector (48) **characterized in that** the first photodetector (47) and the second photodetector (48) having a common node (50); the first photodetector (47) and the second photodetector (48) being configured to respectively generate a first current (I1) entering the common node (50) and a second current (12) outgoing from the common node (50) in response to a respective photonic excitation; one of the first photodetector (47) and the second photodetector (48) being arranged so as to detect the light in a region of the chamber (18) comprising at least a part of the first sliding contact (27), the other of the first photodetector (47) and the second photodetector (48) being arranged so as to detect the light in a region of the chamber (18) not comprising the first sliding contact (27); and
- a control device (34) configured to calculate at least one operating state of at least the first sliding contact (27) on the basis of a signal indicative of an electrical quantity at the common node (50).

2. Alternator according to claim 1, wherein the monitoring device (8) comprises a first line (40) having a first electric potential, a second line (41) having a second electric potential; the first photodetector (47) being connected to the first line (40) and to the common node (50); the second photodetector (48) being connected to the second line (41) and to the common node (50).

3. Alternator according to claim 2, wherein the second line (41) is connected to ground.

4. Alternator according to claim 2 or 3, wherein the first line (40) has an electric potential comprised between 4V and 6V, preferably 5V.

5. Alternator according to anyone of the foregoing claims, wherein the monitoring device (8) comprises at least one load assembly (44) provided with a first load (51) connected to the first line (40) and to the common node (50) and with a second load (52) connected to the second line (41) and to the common node (50).

6. Alternator according to claim 5, wherein the first load (51) and the second load (52) have the same value of electric resistance.

7. Alternator according to anyone of the foregoing claims, comprising a third photodetector (47) and a fourth photodetector (48) connected to the common node (50).

8. Alternator according to claim 7, wherein the third photodetector (47) is substantially identical to the first photodetector (47) and the fourth photodetector (48) is substantially identical to the second photodetector (48).

9. Alternator according to anyone of the foregoing claims, wherein the first photodetector (47) and the second photodetector (48) are semiconductors photoconductive detectors, preferably photodiodes.

10. Alternator according to anyone of the foregoing claims, wherein the control device (34) is configured to signal the operating state of the sliding contact (27) by an interface (35).

11. Method for monitoring the conditions of at least one sliding contact (27) of an alternator (3), preferably for an electric power plant (1), extending along a longitudinal axis (A); the alternator (3) comprising a stator (5), a rotor (6), which is housed inside the stator (5) and is provided with a rotating shaft (4) and with a plurality of electromagnets, and a collector assembly (7), which is configured to supply current to the electromagnets of the rotor (6) and is provided with a chamber (18) and at least one first sliding contact (27) housed inside the chamber (18);
the method comprising the steps of:
- detecting light events associated to at least one first sliding contact (27) by at least one first photodetector (47) and one second photodetector (48) having a common node (50); the first photodetector (47) and the second photodetector (48) being configured to respectively generate a first current (I1) entering the common node (50) and a second current (12) outgoing from the common node (50) in response to a respective photonic excitation; one of the first photodetector (47) and the second photodetector (48) being arranged so as to detect the light in a region of the chamber (18) comprising at least a part of the first sliding contact (27), the other of the first photodetector (47) and the second photodetector (48) being arranged so as to detect the light in a region of the chamber (18) not comprising the first sliding contact (27);
- calculating at least one operating state of at least the first sliding contact (27) on the basis of a signal indicative of an electrical quantity at the common node (50).

12. Method according to claim 11, comprising the step of signaling, by an interface (35), the operating state of at least the first sliding contact (27).

## Patentansprüche

1. Wechselstromgenerator, vorzugsweise für ein Elektrizitätswerk (1), der sich entlang einer longitudinalen Achse (A) erstreckt und einen Stator (5), einen Rotor (6), der in dem Stator (5) aufgenommen ist und mit einer Drehwelle (4) sowie mit mehreren Elektromagneten versehen ist, und eine Kollektoranordnung (7), die konfiguriert ist, an die Elektromagneten des Rotors (6) Strom zu liefern, und mit einer Kammer (18) sowie mit wenigstens einem Gleitkontakt (27), der in der Kammer (18) aufgenommen ist, versehen ist, umfasst; wobei der Wechselstromgenerator (3) Folgendes umfasst:
- eine Überwachungsvorrichtung (8) zum Überwachen der Zustände wenigstens des ersten Gleitkontakts (27), die wenigstens einen ersten Photodetektor (47) und einen zweiten Photodetektor (48) enthält,
**dadurch gekennzeichnet, dass** der erste Photodetektor (47) und der zweite Photodetektor (48) einen gemeinsamen Knoten (50) besitzen; wobei der erste Photodetektor (47) und der zweite Photodetektor (48) konfiguriert sind, in Reaktion auf eine jeweilige Erregung durch Photonen einen ersten Strom (I1), der in den gemeinsamen Knoten (50) eintritt, bzw. einen zweiten Strom (I2), der den gemeinsamen Knoten (50) verlässt, zu erzeugen; wobei entweder der erste Photodetektor (47) oder der zweite Photodetektor (48) so angeordnet ist, dass er das Licht in einem Bereich der Kammer (18) detektiert, der wenigstens einen Teil des ersten Gleitkontakts (27) enthält, während der andere des ersten Photodetektors (47) und des zweiten Photodetektors (48) so angeordnet ist, dass er das Licht in einem Bereich der Kammer (18) detektiert, der den ersten Gleitkontakt (27) nicht enthält; und
- eine Steuervorrichtung (34), die konfiguriert ist, wenigstens einen Betriebszustand wenigstens des ersten Gleitkontakts (27) anhand eines Signals, das eine elektrische Größe bei dem gemeinsamen Knoten (50) angibt, zu berechnen.

2. Wechselstromgenerator nach Anspruch 1, wobei die Überwachungsvorrichtung (8) eine erste Leitung (40) auf einem ersten elektrischen Potenzial und eine zweite Leitung (41) auf einem zweiten elektrischen Potenzial enthält; wobei der erste Photodetektor (47) mit der ersten Leitung (40) und mit dem gemeinsamen Knoten (50) verbunden ist; und der zweite Photodetektor (48) mit der zweiten Leitung und mit dem gemeinsamen Knoten (50) verbunden ist.

3. Wechselstromgenerator nach Anspruch 2, wobei die zweite Leitung (41) mit Masse verbunden ist.

4. Wechselstromgenerator noch Anspruch 2 oder 3, wobei die erste Leitung (40) auf einem elektrischen Potenzial im Bereich von 4 V bis 6 V, vorzugsweise von 5 V, liegt.

5. Wechselstromgenerator nach einem der vorhergehenden Ansprüche, wobei die Überwachungsvorrichtung (8) wenigstens eine Lastanordnung (40) enthält, die eine mit der ersten Leitung (40) und mit dem gemeinsamen Knoten (50) verbundene erste Last (51) und eine mit der zweiten Leitung (41) und mit dem gemeinsamen Knoten (50) verbundene zweite Last (52) umfasst.

6. Wechselstromgenerator nach Anspruch 5, wobei die erste Last (51) und die zweite Last (52) den gleichen elektrischen Widerstandwert haben.

7. Wechselstromgenerator nach einem der vorhergehenden Ansprüche, der einen dritten Photodetektor (47) und einen vierten Photodetektor (48), die mit dem gemeinsamen Knoten (50) verbunden sind, umfasst.

8. Wechselstromgenerator nach Anspruch 7, wobei der dritte Photodetektor (47) mit dem ersten Photodetektor (47) im Wesentlichen übereinstimmt und der vierte Photodetektor (48) mit dem zweiten Photodetektor (48) in Wesentlichen übereinstimmt.

9. Wechselstromgenerator nach einem der vorhergehenden Ansprüche, wobei der erste Photodetektor (47) und der zweite Photodetektor (48) photoleitende Halbleiterdetektoren, vorzugsweise Photodioden, sind.

10. Wechselstromgenerator nach einem der vorhergehenden Ansprüche, wobei die Steuervorrichtung (34) konfiguriert ist, den Betriebszustand des Gleitkontakts (27) über eine Schnittstelle (35) zu übermitteln.

11. Verfahren zum Überwachen der Zustände wenigstens eines Gleitkontakts (27) eines Wechselstromgenerators (3), vorzugsweise eines Elektrizitätswerks (1), der sich längs eine longitudinale Achse (A) erstreckt; wobei der Wechselstromgenerator (3) einen Stator (5), einen Rotor (6), der in dem Stator (5) aufgenommen ist und mit einer Drehwelle (4) sowie mit mehreren Elektromagneten versehen ist, und eine Kollektoranordnung (7), die konfiguriert ist, an die Elektromagneten des Rotors (6) Strom zu liefern, und mit einer Kammer (18) und mit wenigstens einem in der Kammer (18) aufgenommenen ersten Gleitkontakt (27) versehen ist, umfasst;
wobei das Verfahren die folgenden Schritte umfasst:
- Detektieren von Lichtereignissen, die wenigstens einem ersten Gleitkontakt (27) zugeordnet sind, durch wenigstens einen ersten Photodetektor (47) und einen zweiten Photodetektor (48), die einen gemeinsamen Knoten (50) haben; wobei der erste Photodetektor (47) und der zweite Photodetektor (48) konfiguriert sind, in Reaktion auf eine jeweilige Erregung durch Photonen einen ersten Strom (I1), der in den gemeinsamen Knoten (50) eintritt, bzw. einen zweiten Strom (I2), der den gemeinsamen Knoten (50) verlässt, zu erzeugen; wobei entweder der erste Photodetektor (47) oder der zweite Photodetektor (48) so angeordnet ist, dass er das Licht in einem Bereich der Kammer (18) detektiert, der wenigstens einen Teil des ersten Gleitkontakts (27) enthält, während der andere des ersten Photodetektors (47) und des zweiten Photodetektors (48) so angeordnet ist, dass er das Licht in einem Bereich der Kammer (18) detektiert, der den ersten Gleitkontakt (27) nicht enthält;
- Berechnen wenigstens eines Betriebszustands wenigstens des ersten Gleitkontakts (27) anhand eines Signals, das eine elektrische Größe bei dem gemeinsamen Knoten (50) angibt.

12. Verfahren nach Anspruch 11, das den Schritt des Übermittelns durch eine Schnittstelle (35) des Betriebszustandes wenigstens des ersten Gleitkontakts (27) umfasst.

## Revendications

1. Alternateur, de préférence pour une centrale électrique (1), s'étendant le long d'un axe longitudinal (A) et comprenant un stator (5), un rotor (6), qui est logé à l'intérieur du stator (5) et qui est pourvu d'un arbre rotatif (4) et d'une pluralité d'électroaimants, et un ensemble de collecteur (7), qui est configuré pour fournir un courant aux électroaimants du rotor (6) et qui est pourvu d'une chambre (18) et au moins d'un premier contact coulissant (27) logé à l'intérieur de la chambre (18) ; l'alternateur (3) comprenant :
- un dispositif de surveillance (8) pour surveiller les conditions au moins du premier contact coulissant (27) et comprenant au moins un premier photodétecteur (47) et un deuxième photodétecteur (48), **caractérisé en ce que** le premier photodétecteur (47) et le deuxième photodétecteur (48) ont un noeud commun (50) ; le premier photodétecteur (47) et le deuxième photodétecteur (48) sont configurés pour générer respectivement un premier courant (11) entrant dans le noeud commun (50) et un deuxième courant (I2) sortant du noeud commun (50) en réponse à une excitation photonique respective ; l'un parmi le premier photodétecteur (47) et le deuxième photodétecteur (48) est agencé de manière à détecter la lumière dans une région de la chambre (18) comprenant au moins une partie du premier contact coulissant (27), l'autre parmi le premier photodétecteur (47) et le deuxième photodétecteur (48) est agencé de manière à détecter la lumière dans une région de la chambre (18) ne comprenant pas le premier contact coulissant (27) ; et
- un dispositif de commande (34) configuré pour calculer au moins un état de fonctionnement au moins du premier contact coulissant (27) sur la base d'un signal indicatif d'une quantité électrique au niveau du noeud commun (50).

2. Alternateur selon la revendication 1, dans lequel le dispositif de surveillance (8) comprend une première ligne (40) ayant un premier potentiel électrique, une deuxième ligne (41) ayant un deuxième potentiel électrique ; le premier photodétecteur (47) étant connecté à la première ligne (40) et au noeud commun (50) ; le deuxième photodétecteur (48) étant connecté à la deuxième ligne (41) et au noeud commun (50).

3. Alternateur selon la revendication 2, dans lequel la deuxième ligne (41) est connectée à la masse.

4. Alternateur selon la revendication 2 ou 3, dans lequel la première ligne (40) a un potentiel électrique compris entre 4 V et 6 V, de préférence de 5 V.

5. Alternateur selon l'une quelconque des revendications précédentes, dans lequel le dispositif de surveillance (8) comprend au moins un ensemble de charges (44) pourvu d'une première charge (51) connectée à la première ligne (40) et au noeud commun (50) et d'une deuxième charge (52) connectée à la deuxième ligne (41) et au noeud commun (50).

6. Alternateur selon la revendication 5, dans lequel la première charge (51) et la deuxième charge (52) ont la même valeur de résistance électrique.

7. Alternateur selon l'une quelconque des revendications précédentes, comprenant un troisième photodétecteur (47) et un quatrième photodétecteur (48) connectés au noeud commun (50).

8. Alternateur selon la revendication 7, dans lequel le troisième photodétecteur (47) est sensiblement identique au premier photodétecteur (47) et le quatrième photodétecteur (48) est sensiblement identique au deuxième photodétecteur (48).

9. Alternateur selon l'une quelconque des revendications précédentes, dans lequel le premier photodétecteur (47) et le deuxième photodétecteur (48) sont des détecteurs photoconducteurs à semi-conducteurs, de préférence des photodiodes.

10. Alternateur selon l'une quelconque des revendications précédentes, dans lequel le dispositif de commande (34) est configuré pour signaler l'état de fonctionnement du contact coulissant (27) par une interface (35).

11. Procédé pour surveiller les conditions d'au moins un contact coulissant (27) d'un alternateur (3), de préférence pour une centrale électrique (1), s'étendant le long d'un axe longitudinal (A) ; l'alternateur (3) comprenant un stator (5), un rotor (6), qui est logé à l'intérieur du stator (5) et qui est pourvu d'un arbre rotatif (4) et d'une pluralité d'électroaimants, et un ensemble de collecteur (7), qui est configuré pour fournir un courant aux électroaimants du rotor (6) et qui est pourvu d'une chambre (18) et d'au moins un premier contact coulissant (27) logé à l'intérieur de la chambre (18) ;
le procédé comprenant les étapes :
- de détection d'événements de lumière associés à au moins un premier contact coulissant (27) par au moins un premier photodétecteur (47) et un deuxième photodétecteur (48) ayant un noeud commun (50) ; le premier photodétecteur (47) et le deuxième photodétecteur (48) étant configurés pour générer respectivement un premier courant (11) entrant dans le noeud commun (50) et un deuxième courant (I2) sortant du noeud commun (50) en réponse à une excitation photonique respective ; l'un parmi le premier photodétecteur (47) et le deuxième photodétecteur (48) étant agencé de manière à détecter la lumière dans une région de la chambre (18) comprenant au moins une partie du premier contact coulissant (27), l'autre parmi le premier photodétecteur (47) et le deuxième photodétecteur (48) étant agencé de manière à détecter la lumière dans une région de la chambre (18) ne comprenant pas le premier contact coulissant (27) ;
- de calcul d'au moins un état de fonctionnement au moins du premier contact coulissant (27) sur la base d'un signal indicatif d'une quantité électrique au niveau du noeud commun (50).

12. Procédé selon la revendication 11, comprenant l'étape de signalisation, par une interface (35), de l'état de fonctionnement au moins du premier contact coulissant (27).
